# EUROPÄISCHE PATENTANMELDUNG

(11) **EP 1 049 191 A2**
(43) Veröffentlichungstag der Anmeldung: **02.11.2000**
(21) Anmeldenummer: 00201152.6
(22) Anmeldetag: 28.03.2000
(51) Int. Cl.: H01P 1/00

(54) **Verfahren zur Herstellung von elektronischen Bauelementen mit Streifenleitungen**

(30) Priorität: 03.04.1999 DE 19915245
(71) Anmelder: Philips Corporate Intellectual Property GmbH, 52064 Aachen (DE); Koninklijke Philips Electronics N.V., 5621 BA Eindhoven (NL)
(72) Erfinder: Löbl, Hans-Peter, Philips Corporate, 52064 Aachen (DE); Klee, Mareike, Philips Corporate, 52064 Aachen (DE); Fleuster, Martin, Philips Corporate, 52064 Aachen (DE); van Oppen, Paul, Philips Corporate, 52064 Aachen (DE)
(74) Vertreter: Gössmann, Klemens

(57) **Zusammenfassung**

Die Erfindung beschreibt ein Verfahren zur Herstellung eines elektronischen Dünnschichtbauelementes mit wenigstens einer Streifenleitung. Bei diesem Verfahren wird zunächst auf einer Substratschicht (1) eine metallische Basisschicht (2) abgeschieden, auf dieser metallischen Basisschicht (2) eine Schicht aus Fotolack (3) aufgebracht und entsprechend der zu formenden Streifenleitung(en) strukturiert. Auf den freigelegten Bereichen der metallischen Basisschicht (2) wird eine elektrisch leitende Schicht (4) abgeschieden. Anschließend wird der Fotolack (3) entfernt und die metallische Basisschicht geätzt (2). Dieses Verfahren hat den Vorteil, daß weniger Metall benötigt wird als in anderen Dünnschichtverfahren.
Überschneidungen der Streifenleitungen können einfach, günstig und mit geringen Stromkapazitäten mit Hilfe von Brücken (13) realisiert werden.
Mit Hilfe des beschriebenen Verfahrens können auf einfache Weise passive Bauelemente wie beispielsweise Dünnschichtkoppler für Hochfrequenzanwendungen oder Dünnschichtspulen erhalten werden.

## Beschreibung

Die Erfindung betrifft ein Verfahren zur Herstellung von elektronischen Bauelementen mit wenigstens einer Streifenleitung.

Streifenleitungen in ihren verschiedenen Bauformen sind die im VHF- und Mikrowellenbereich sowie bei schnellen Digitalschaltungen überwiegend benutzten Leitungstypen für die Schaltungstechnik, sofern nicht besondere Anforderungen an Dämpfungsarmut oder hohe übertragbare Leistung die Verwendung von Koaxialleitungen oder Hohlleitern erfordern. Mit der Streifenleitungsbauform lassen sich auch in einfacher Weise passive Bauelemente wie beispielsweise Spulen oder Koppler realisieren.

Koppler steilen unter anderem Hochfrequenzbauteile für Mobiltelefone oder Basisstationen dar, die das Auskoppeln von HF-Signalen zwischen dem Ausgang eines Leistungsverstärken und einer Antenne ermöglichen. Das ausgekoppelte Signal wird verwendet, um die Ausgangsleistung des Verstärkers zu regeln. Ein solcher Koppler weist beispielsweise zwei Kopplerschleifen auf, von denen eine Schleife die Hauptschleife darstellt und das Sendesignal möglichst verlustfrei übertragen soll. Die zweite Schleife, die sogenannte Nebenschleife, koppelt im Vergleich mit dem Sendesignal ein kleines Signal aus.

Bekannt sind solche Koppler in verschiedenen Ausführungsformen. Zum einen gibt es Koppler in keramischer Vielschichtbauweise. Bei diesen keramischen Kopplern werden die Elektrodenstrukturen auf keramische Folien gedruckt, die Folien werden gestapelt und dann zu Bauelementen gesintert. Der Nachteil bei diesem Druckverfahren ist die grobkörnige Morphologie der Elektroden, was einen höheren elektrischen Widerstand zur Folge hat. Ein weiterer Nachteil ist die geringe Genauigkeit der Druckverfahren. Dies kann zu einer Streuung der elektronischen Eigenschaften führen.

Daneben gibt es Ausführungen in Mikrostreifenausführung. In 1991 IEEE MTT-S International Microwave Symposium Digest, Volume II, 857-860 wird ein Dünnschichtkoppler beschrieben, der zwei Streifenleitungen als Kopplerschleifen aufweist. Aufgebracht sind die beiden Kopplerschleifen auf einem dielektrischen Substrat mit hoher dielektrischer Konstante K. Auf der Rückseite des keramischen Substrats befindet sich als Erdungsebene noch eine metallische Schicht. Außerdem sind am Bauelement sechs Endkontakte befestigt, von denen jeweils zwei in Kontakt mit einer Kopplerschleife stehen und zwei mit der Erdungsebene verbunden sind.

Der Erfindung liegt die Aufgabe zugrunde, ein Verfahren bereitzustellen, mit dem einfach, preiswert und mit hoher Genauigkeit elektronische Bauelemente mit wenigstens einer Streifenleitung, insbesondere Koppler, hergestellt werden können.

Die Aufgabe wird gelöst durch ein Verfahren zur Herstellung elektronischer Bauelemente mit wenigstens einer Streifenleitung, bei dem auf einer Substratschicht eine metallische Basisschicht abgeschieden wird, auf dieser metallischen Basisschicht eine Schicht aus Fotolack aufgebracht und strukturiert wird, auf den freigelegten Bereichen der metallischen Basisschicht eine elektrisch leitende Schicht abgeschieden wird, der Fotolack entfernt wird und die metallische Basisschicht geätzt wird.

Dieses Verfahren hat den Vorteil, daß weniger Metall benötigt wird als in anderen Dünnschichtverfahren. In den bekannten Dünnschichtprozessen wird zunächst die elektrisch leitende Schicht abgeschieden und diese dann mittels fotolithografischer Prozesse strukturiert. In dem erfindungsgemäßen Verfahren wird auf die dünne metallische Basisschicht eine preiswerte Schicht aus Fotolack aufgebracht und strukturiert. Anschließend wird die elektrisch leitende Schicht, in die Löcher des Fotolackes, auf die freiliegende metallische Basisschicht abgeschieden. Mit Hilfe dieses Verfahrens können kompakte Bauelemente mit kleinen Abmessungen erhalten werden.

Es ist bevorzugt, daß als Material für die Substratschicht ein keramisches Material, ein keramisches Material mit einer Planarisierungsschicht aus Glas, ein glaskeramisches Material oder ein Glasmaterial verwendet wird.

Eine Substratschicht aus diesen Materialien ist kostengünstig herzustellen und die Prozeßkosten für diese Komponente können niedrig gehalten werden.

Es ist weiterhin bevorzugt, daß als Material für die metallische Basisschicht Cr/Cu verwendet wird.

Eine metallische Basisschicht wird aufgebracht, um die spätere Abscheidung der elektrisch leitenden Schicht zu erleichtern und die Haftung der Streifenleitung auf der Substratschicht zu verbessern.

Es ist auch bevorzugt, daß als Material für die elektrisch leitende Schicht Cu, Ag, Al oder Au verwendet wird.

Diese Materialien sind allesamt gut leitende Metalle.

Es ist bevorzugt, daß bei einem Bauelement mit zwei oder mehr Streifenleitungen die Streifenleitungen in einer Ebene liegen.

Diese Bauelemente sind einfach und preiswert herzustellen, da die Streifenleitungen im selben Prozeßschritt hergestellt werden können.

Es kann bevorzugt sein, daß sich bei einem Bauelement mit zwei oder mehr Streifenleitungen die Streifenleitungen wenigstens einmal überschneiden.

Mit Hilfe von Überschneidungen der Streifenleitungen sind vielfältige, den Anforderungen an das Bauelement entsprechende, Variationen der Länge und der Geometrie der Streifenleitungen möglich.

In dieser Ausführungsform ist es bevorzugt, daß Überschneidungen der Streifenleitungen mittels Brücken aus einem leitfähigen Material realisiert werden.

Mit Hilfe von Brücken sind Überschneidungen der Streifenleitungen auf einfache Art möglich. Die in einer Ebene liegenden Abschnitte der Streifenleitungen können weiterhin im selben Prozeßschritt auf der Substratschicht aufgebracht werden. Die Vervollständigung der jeweiligen Streifenleitung mittels einer Brücke aus einem leitfähigen Material erfolgt in einem nachgeschalteten Prozeßschritt.

Es ist weiterhin bevorzugt, daß jedes Ende einer Streifenleitung in elektrischem Kontakt mit einer Stromzuführung steht.

An den Stromzuführungen kann jedes Bauelement mit weiteren Bauelementen eines Schaltkreises elektrisch verbunden werden. Je nach Art der Applikation oder Art der Bauteilmontage kann als Stromzuführung ein galvanischer SMD-Endkontakt oder ein Bumpend-Kontakt oder eine Kontaktfläche eingesetzt werden. Durch die Verwendung von SMD-Endkontakten oder Bump-end-Kontakten können diskrete Bauelemente hergestellt werden.

Es ist außerdem bevorzugt, daß über dem Bauelement eine Schutzschicht aus einem anorganischen Material und/oder einem organischen Material aufgebracht wird.

Durch die Schutzschicht wird das Bauelement vor mechanischer Beanspruchung und Korrosion durch Feuchtigkeit geschützt.

Es kann vorteilhaft sein, daß auf der Unterseite der Substratschicht eine Erdungsebene aufgebracht wird. In dieser vorteilhaften Ausführungsform ist es bevorzugt, daß die Metallschicht mit wenigstens einer weiteren Stromzuführung verbunden wird.

Im folgenden soll die Erfindung anhand von sieben Figuren und zweier Ausführungsbeispiele erläutert werden. Dabei zeigt
- Fig. 1:: ein Fließschema zur Herstellung eines Bauelementes mit wenigstens einer Streifenleitung,
- Fig. 2:: ein Fließschema zur Abscheidung einer Schutzschicht und Herstellung einer metallischen Basisschicht für Stromzuführungen,
- Fig. 3:: eine Aufsicht auf einen Koppler, bei dem die Streifenleitungen in einer Ebene liegen,
- Fig. 4:: eine Aufsicht auf einen Koppler, bei dem sich die Streifenleitungen überschneiden,
- Fig. 5:: im Querschnitt eine Überschneidungen von Streifenleitungen mittels Brücken,
- Fig. 6:: eine Aufsicht auf eine Spule in Streifenleitungsbauform und
- Fig. 7:: im Querschnitt eine Spule in Streifenleitungsbauform.

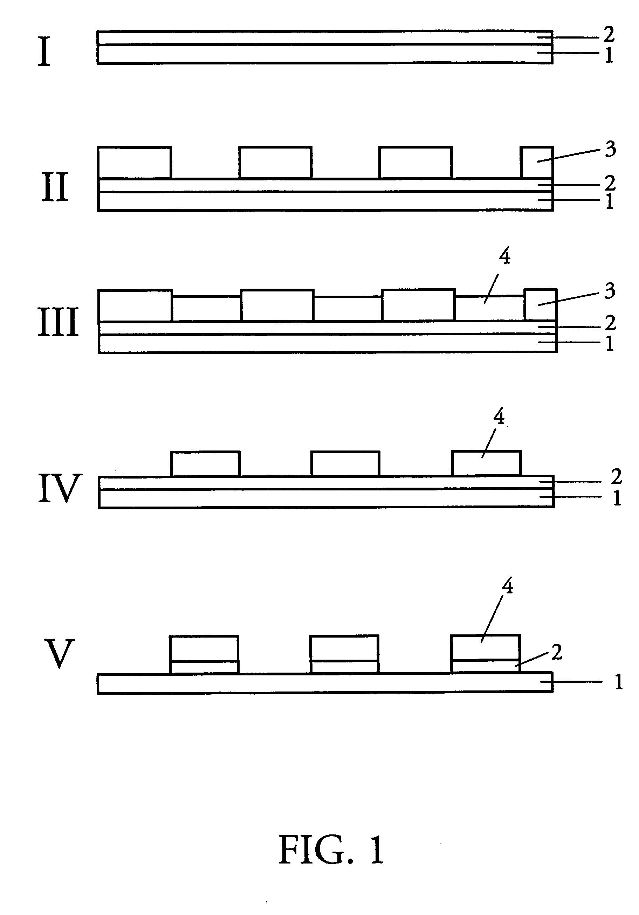

Gemäß Verfahrensschritt I in Fig. 1 wird zunächst auf einer Substratschicht 1, welche beispielsweise ein keramisches Material, ein keramisches Material mit einer Planarisierungsschicht aus Glas, ein glaskeramisches Material oder ein Glasmaterial enthält, eine metallische Basisschicht 2 abgeschieden. Diese metallische Basisschicht 2 kann zum Beispiel Cr/Cu enthalten. Auf diese metallische Basisschicht 2 wird eine Schicht 3 aus Fotolack aufgebracht und entsprechend der zu formenden Streifenleitung strukturiert (Verfahrensschritt II in Fig. 1). Anschließend wird die metallische Basisschicht 2 durch Abscheidung einer elektrisch leitenden Schicht 4 verstärkt bis die Streifenleitung die gewünschte Dicke aufweist (Verfahrensschritt III in Fig. 1). Dies kann beispielsweise galvanisch geschehen. Als Material für diese elektrisch leitende Schicht 4 wird ein gut leitendes Metall wie beispielsweise Cu, Ag, Al oder Au verwendet. Im nächsten Schritt wird der Fotolack 3 entfernt (Verfahrensschritt IV in Fig. 1) und anschließend wird die metallische Basisschicht 2 geätzt (Verfahrensschritt V in Fig. 1). Dies kann durch naßchemische Ätzverfahren oder durch physikalisches Ätzen erfolgen.

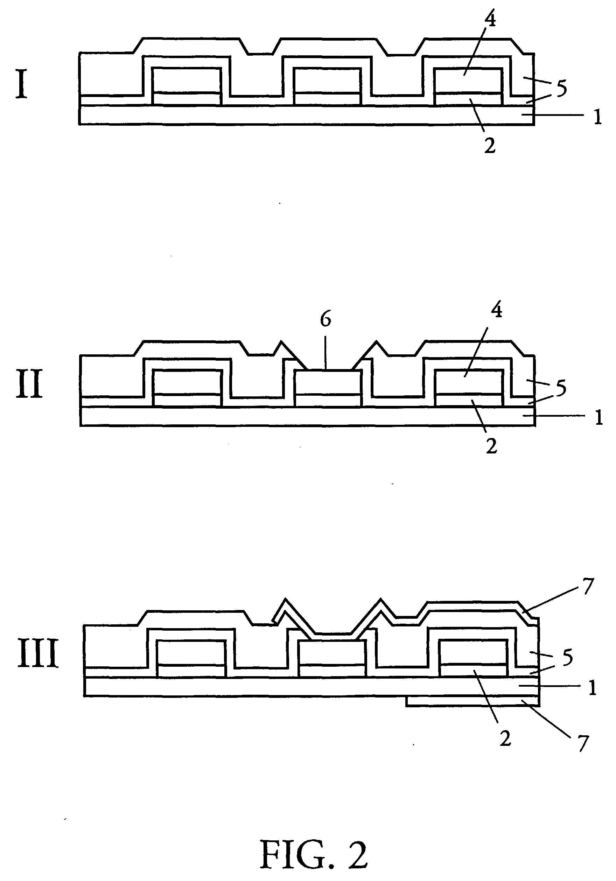

Gemäß Verfahrensschritt I in Fig. 2 wird über dem gesamten Bauelement eine oder mehrere Schutzschichten 5 aus einem organischen und/oder anorganischen Material aufgebracht. Als organisches Material kann beispielsweise Polybenzocyclobuten oder Polyimid und als anorganisches Material kann zum Beispiel Si₃N₄, SiO₂ oder SiₓO_{y}N_{z} (0 ≤ x ≤ 1, 0 ≤ y ≤ 1, 0 ≤ z ≤ 1) verwendet werden. Im Anschluß wird für eine spätere elektrische Kontaktierung der Streifenleitungen ein Via 6 durch die Schurzschichten 5 geätzt (Verfahrensschritt II in Fig. 2). Dies kann bei fotosensitiven Schutzschichtmaterialien mittels fotolithografischer Prozesse erfolgen oder anderenfalls mittels naß-chemischen Ätzens. Anschließend wird eine weitere metallische Basisschicht 7 beispielsweise aus Cr/Cu oder Cr/Ni auf den Teilen des Bauelementes abgeschieden, wo die Stromzuführungen angebracht werden sollen und dort wo sich elektrische Kontaktierung der Streifenleitung befindet (Verfahrensschritt III in Fig. 2).

Zur Herstellung von SMD-Endkontakten als Stromzuführung kann die metallische Basisschicht 7 durch galvanische Abscheidung von Ni/Sn, Cu/Ni/Sn oder Pb/Sn verstärkt werden. Alternativ können auch ein Bump-end-Kontakt oder eine Kontaktfläche als Stromzuführung eingesetzt werden.

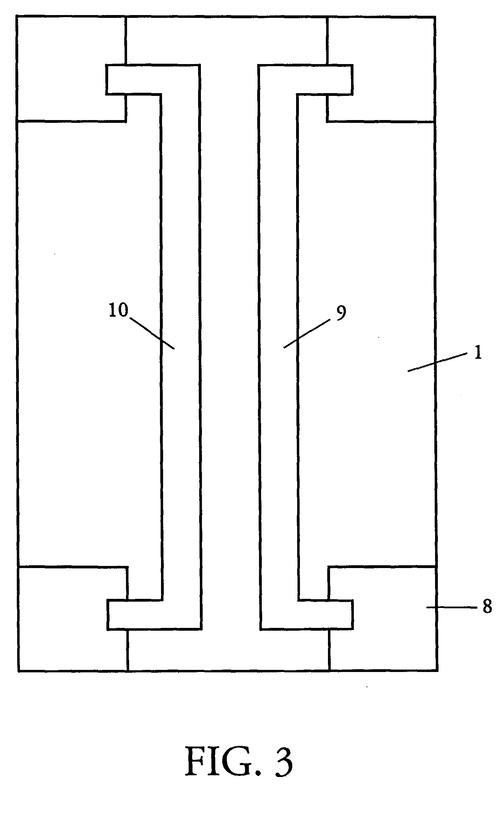

Gemäß Fig. 3 weist ein Koppler zwei Streifenleitungen auf: eine Hauptschleife 9 und eine Nebenschleife 10. Beide Kopplerschleifen befinden sich in einer Ebene auf einer Substratschicht 1. Außerdem sind am Bauelement vier Stromzuführungen 8 befestigt, von denen jeweils zwei Stromzuführungen über eine der beiden Kopplerschleife miteinander verbunden sind.

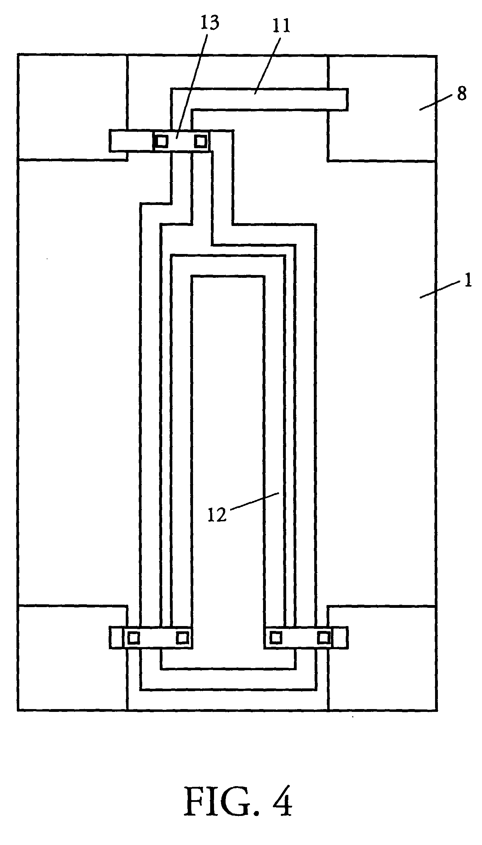

In Fig. 4 ist ein Koppler gezeigt, bei dein es zu Überschneidungen von zwei Kopplerschleifen 11 und 12 kommt. Diese Überschneidungen werden durch Brücken 13 realisiert.

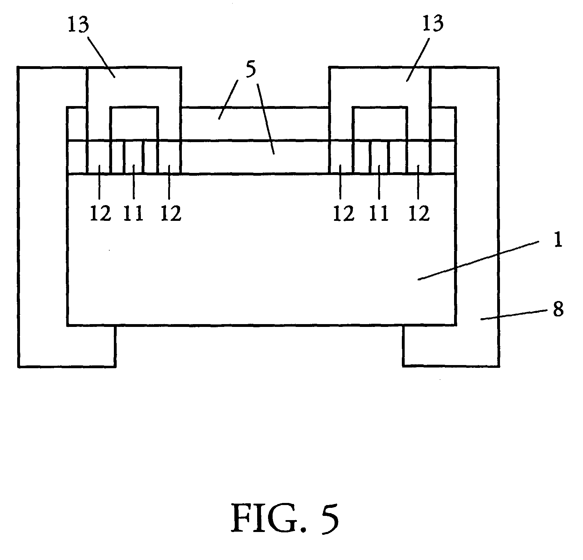

In Fig. 5 sind Überschneidungen der Streifenleitungen 11 und 12 gezeigt. Zunächst werden die Abschnitte der Streifenleitungen 11 und 12 die in einer Ebene liegen abgeschieden. Anschließend werden die Abschnitte durch Brücken 13 elektrisch miteinander verbunden. Die Brücken 13 werden bei Herstellung der Stromzuführungen 8 im selben Material ausgeführt.

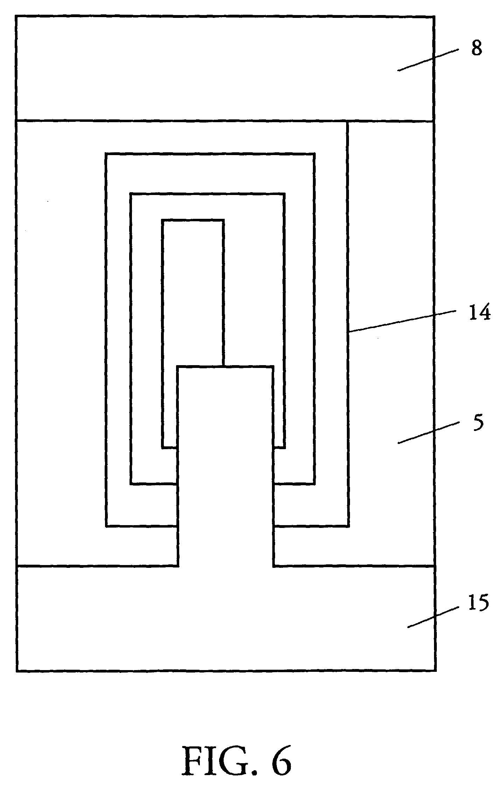

In Fig. 6 ist eine Spule gezeigt, bei der die Windungen 14 als spiralförmig zulaufende Streifenleitungen ausgeführt sind. Außerdem sind auf gegenüberliegenden Seiten des Bauelementes Stromzuführungen 8 und 15 angebracht. Die Stromzuführung 15 stellt gleichzeitig den elektrischen Kontakt mit dem Zentrum der Spule her.

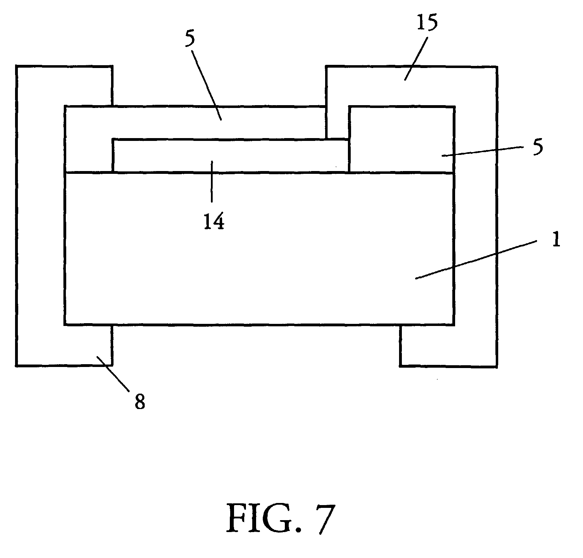

Gemäß Fig. 7 weist eine solche Spule eine Streifenleitung 14 auf; die auf einer Substratschicht 1 aufgebracht ist auf. Über dem gesamten Bauelement wurde eine Schutzschicht 5 aufgebracht. Über eine Verlängerung der Stromzuführung 15 durch die Schutzschicht 5 wird der elektrische Kontakt zu der Streifenleitung 14 hergestellt.

Alternativ kann bei allen Bauelementen auf der Rückseite der Substratschicht 1 eine Erdungsebene, welche beispielsweise Cu enthält, aufgebracht werden. Zusätzlich kann diese Erdungsebene mit wenigstens einer weiteren Stromzuführung verbunden werden.

Im folgenden werden Ausführungsformen der Erfindung erläutert, die beispielhafte Realisierungsmöglichkeiten darstellen.

### Ausführungsbeispiel 1:

Zur Herstellung eines Dünnschichtkopplers mit Streifenleitungen ohne Überschneidungen wurde auf einer Substratschicht 1 aus Al₂O₃ mit einer Planarisierungsschicht aus Glas eine metallische Basisschicht 2 aus Ni/Cr abgeschieden. Anschließend wurde auf dieser metallischen Basisschicht 2 eine Schicht aus Fotolack 3 aufgebracht. Diese Schicht aus Fotolack 3 wurde mittels fotolithografischer Prozesse so strukturiert, daß die Schicht aus Fotolack 3 das Muster der gewünschten Kopplerschleifen aufwies. Im nächsten Schritt wurde eine elektrisch leitende Schicht aus Cu galvanisch auf die freiliegende metallische Basisschicht 2 aus Ni/Cr abgeschieden und anschließend wurde der Fotolack entfernt. Über dem gesamten Bauelement wurde eine Schutzschicht 5 aus Polyimid und Si₃N₄ aufgebracht. Außerdem wurden vier Cr/Cu, Cu/Ni/Sn SMD-Endkontakte als Stromzuführungen 8 am Bauelement befestigt.

### Ausführungsbeispiel 2:

Zur Realisierung eines Dünnschichtkopplers mir zwei sich überschneidenden Streifenleitungen aus Cr/Cu, Cu wurden auf eine Substratschicht 1 aus Al₂O₃ mit einer Planarisierungsschicht aus Glas zunächst die Teile der Streifenleitungen 11 und 12 aufgebracht, die in einer Ebene liegen. Anschließend wurden über dem gesamten Bauelement mehrere Schurzschichten 5 aus Polyimid und Si₃N₄ aufgebracht. An den jeweiligen Enden der Abschnitte der Streifenleitungen 11 und 12 wurden Vias durch die Schutzschichten 5 geätzt. Anschließend wurde eine metallische Basisschicht 7 aus Cr/Cu in die Vias und auf den Teilen des Bauelementes abgeschieden, wo die Stromzuführungen angebracht werden sollen. Zur Herstellung von Cr/Cu, Cu/Ni/Sn SMD-Endkontakten als Stromzuführung 8 und zur Vervollständigung der Brücken 13 wurde die metallische Basisschicht 7 durch galvanische Abscheidung von Cu/Ni/Sn verstärkt.

### Ausführungsbeispiel 3:

Eine Spule in Streifenleitungsbauart weist eine Substratschicht 1 aus Glas auf, auf der eine Streifenleitung 14 aus Cr/Cu, Cu spiralförmig aufgebracht wurde. Über dem gesamten Bauelement wurde eine Schutzschicht 5 aus Polyimid abgeschieden. Auf jeder Seite des Bauelementes wurde je ein Cr/Cu, Cu/Ni/Sn SMD-Endkontakt als Stromzuführungen 8 und 15 befestigt. Über eine Verlängerung steht die Stromzuführung 15 mit dem Zentrum der spiralförmig zulaufenden Streifenleitung 14 in elektrischem Kontakt.

## Patentansprüche

1. Verfahren zur Herstellung elektronischer Bauelemente mit wenigstens einer Streifenleitung,
dadurch gekennzeichnet,
daß
- auf einer Substratschicht (1) eine metallische Basisschicht abgeschieden wird,
- auf dieser metallischen Basisschicht (2) eine Schicht aus Fotolack (3) aufgebracht und strukturiert wird,
- auf den freigelegten Bereichen der metallischen Basisschicht (2) eine elektrisch leitende Schicht (4) abgeschieden wird,
- der Fotolack (3) entfernt wird und
- die metallische Basisschicht (2) geätzt wird.

2. Verfahren zur Herstellung elektronischer Bauelemente mit wenigstens einer Streifenleitung nach Anspruch 1,
dadurch gekennzeichnet,
daß als Material für die Substratschicht (1) ein keramisches Material, ein keramisches Material mit einer Planarisierungsschicht aus Glas, ein glaskeramisches Material oder ein Glasmaterial verwendet wird.

3. Verfahren zur Herstellung elektronischer Bauelemente mit wenigstens einer Streifenleitung nach Anspruch 1,
dadurch gekennzeichnet,
daß als Material für die metallische Basisschicht (2) Cr/Cu verwendet wird.

4. Verfahren zur Herstellung elektronischer Bauelemente mit wenigstens einer Streifenleitung nach Anspruch 1,
dadurch gekennzeichnet,
daß als Material für die elektrisch leitende Schicht (4) Cu, Ag, Al oder Au verwendet wird.

5. Verfahren zur Herstellung elektronischer Bauelemente mit wenigstens einer Streifenleitung nach Anspruch 1,
dadurch gekennzeichnet,
daß bei einem Bauelement mit zwei oder mehr Streifenleitungen die Streifenleitungen (9,10) in einer Ebene liegen.

6. Verfahren zur Herstellung elektronischer Bauelemente mit wenigstens einer Streifenleitung nach Anspruch 1,
dadurch gekennzeichnet,
daß sich bei einem Bauelement mit zwei oder mehr Streifenleitungen die Streifenleitungen (11,12) wenigstens einmal überschneiden.

7. Verfahren zur Herstellung elektronischer Bauelemente mit wenigstens einer Streifenleitung nach Anspruch 6,
dadurch gekennzeichnet,
daß Überschneidungen mittels Brücken (13) aus einem leitfähigen Material realisiert werden.

8. Verfahren zur Herstellung elektronischer Bauelemente mit wenigstens einer Streifenleitung nach Anspruch 1,
dadurch gekennzeichnet,
daß jedes Ende einer Streifenleitung mit einer Stromzuführung (8) in Kontakt steht.

9. Verfahren zur Herstellung elektronischer Bauelemente mit Wenigstens einer Streifenleitung nach Anspruch 1,
dadurch gekennzeichnet,
daß über dem Bauelement wenigstens eine Schutzschicht (5) aus einem anorganischen und/oder organischen Material aufgebracht wird.

10. Verfahren zur Herstellung elektronischer Bauelemente mit wenigstens einer Streifenleitung nach Anspruch 1,
dadurch gekennzeichnet,
daß auf der Unterseite der Substratschicht eine Erdungsebene aufgebracht wird.

11. Verfahren zur Herstellung elektronischer Bauelemente mit wenigstens einer Streifenleitung nach Anspruch 10,
dadurch gekennzeichnet,
daß die Erdungsebene mit wenigstens einer weiteren Stromzuführung verbunden wird.
